# EUROPEAN PATENT SPECIFICATION

(11) **EP 4 307 323 B1**
(45) Date of publication and mention of the grant of the patent: **04.12.2024**
(21) Application number: 22184531.6
(22) Date of filing: 12.07.2022
(51) Int. Cl.: H01C 1/01, H01C 1/08, H01C 1/14, H01C 1/012, H01L 23/40

(54) **POWER RESISTOR WITH A CLAMPING ELEMENT FOR IMPROVED COOLING**
LEISTUNGSWIDERSTAND MIT EINEM KLEMMELEMENT ZUR VERBESSERUNG DER KÜHLUNG
RÉSISTANCE DE PUISSANCE AVEC UN ÉLÉMENT DE SERRAGE POUR UN MEILLEUR REFROIDISSEMENT

(43) Date of publication of application: 17.01.2024
(73) Proprietor: Comet AG, 3175 Flamatt (CH)
(72) Inventor: Dennler, Philippe, 3203 Mühleberg (CH); Galos, Adam, 53937 Schleiden (DE); Gruner, Daniel, 79410 Badenweiler (DE); Klanjsek, Janez, 3176 Neuenegg (CH); Labanc, Anton, 79238 Ehrenkirchen (DE); Sistemich, Roland, 52146 Würselen (DE); Staub, Thomas, 3176 Neuenegg (CH)
(74) Representative: dompatent von Kreisler Selting Werner - Partnerschaft von Patent- und Rechtsanwälten mbB

(56) References cited:
- CN-U- 201 984 913
- JP-A- S63 266 858
- US-A- 4 259 685
- US-A- 5 252 944
- US-A- 5 592 021

## Description

The present invention relates to a resistor, in particular for a power combiner of an RF generator.

The handling of reflected power is a particular challenge in radio frequency (RF) power applications for plasma generation, e. g. for the etching and deposition of thin films on silicon wafers during the manufacturing of integrated circuits. RF plasmas are highly dynamic loads which can vary quickly. The use of impedance matching networks between an RF power generator and a plasma can compensate for impedance mismatch in steady-state plasma operation. However, such matching networks are in general too slow to immediately adapt to changes in the load impedance. For example, during the ignition phase of a plasma, during power level changes, and in pulse-mode operation, the RF generator is exposed to transient reflected power which has to be dissipated within the generator.

The RF power stage of an RF generator comprises the following circuits
- Power Amplifier
- Hybrid Combiner
- High-power Combiner (if several PAs are to be combined for higher output power),
and are operating at frequencies in the range of 0.3 - 300 MHz and at power levels of 500 W and higher. For power levels up to approximately 2 kW, air cooling is sufficient, higher power levels above 2 kW typically require water cooling.

In a combiner, termination resistors are typically used for absorbing and dissipating reflected power. Since reflected power levels can get very high depending on the situation, the termination resistor has to be appropriately cooled such that the resulting heat is quickly transferred to a cold plate or heat sink.

The term heat sink refers to a heat exchanger that transfers heat from an electronic circuit to a fluid medium, e. g. air or a liquid coolant. One part of the heat sink typically maximizes the contact, and thus heat transfer, to the fluid medium by an enlarged surface area, e. g. by means of cooling fins or spikes. The term cold plate refers to a heat exchanger through which a liquid coolant is circulated, typically a thick plate with embedded pipes through which the coolant is flowing. Heat sinks and cold plates are typically made from metallic materials, like aluminum, copper, or metallic alloys, but also ceramics and other materials with high thermal conductivity are possible.

A heat spreader is a device with good thermal conductivity, typically a plate, which distributes heat which is generated in a small area to a larger area. A heat spreader is typically used in connection with a heat sink or cold plate by which the heat is transferred to a fluid medium. The distribution of heat in a heat spreader may be enhanced by thermoelectric cooling (e. g. Peltier elements) or by the use of heat pipes.

In the following, the term "cooling element" is used for all types of air-cooled heat exchangers with fins or similar enlarged surface area, for liquid-cooled cold plates, and for combinations of a heat spreader with an air-cooled heat sink or liquid-cooled cold plate, including possible enhancements like thermoelectric cooling or heat pipes.

A typical power resistor, which allows to clamp it to a heat sink with screws, comprises a heat spreader and a resistor chip soldered to this heat spreader.

However, clamping such a resistor from both ends, i.e. clamping only the heat spreader, leads to a reduced pressure and weaker thermal connection in the center of the device where the heat is generated by the resistor chip. Further, the area necessary for the clamping cannot be used by the resistor chip, thereby reducing the maximum possible size of the resistor chip which increases the total heat load in the center of the resistor.

Typical RF generators have to fit into industry-standard electronic racks, and therefore, the width of the generator is often specified to 19/2 or 19 inches, and its height to 3 - 5 rack units, wherein 1 rack unit is 1.75 inches. In consequence, it is difficult to arrange all circuits and components such that they fit the available dimensions, and therefore, the termination resistor has to be placed such that it does not interfere with other circuits or components and consumes minimum space.

Particularly for frequencies below 30 MHz, the circuit components, capacitances and inductances have to be dimensioned with decreasing frequency in larger value and, therefore, size. In consequence, e. g. for the important ISM frequencies of 13.56 and 27.12 MHz, it is difficult to fit all required components of an RF generator into a 19/2-inch enclosure. Consequently, most RF generators with more than 1 kW are forced to use a full 19-inch sized housing.

In modern RF power circuit designs for volume production, in order to achieve low variation from unit to unit, three-dimensional arrangements of wires and ferrites for inductors are avoided because they are difficult to reproduce with the required geometrical precision. Instead, fully planar structures are preferred which can be manufactured with high precision in industrial printed-circuit board (PCB) production. Although, the size of planar circuits is a challenge when 19/2-inch wide enclosures are to be used, advantageously, planar combiners allow to place the termination resistor in the center of an inductor structure.

For best heat transfer, the PCB with such an inductor will have a cut-out in its center such that the power resistor can be clamped directly to the cooling element which serves as a ground connection. To avoid the magnetic field of the inductor to couple into the cooling element, typically made from metal, the PCB with the inductor cannot be placed onto the cooling element directly. Instead, a ceramic heat spreader of several millimeters thickness has to be used to enlarge the distance.

Also, for this resistor assembly, non-magnetic materials must be used. Otherwise, eddy currents would be induced by the magnetic field of the inductor which would cause a heating up of the resistor assembly.

In consequence, the flange of the power resistor via which the ground connection of the termination is established is within a cut-out in the ceramic heat spreader and in direct contact with the cooling element, whereas the connection of the resistor to the inductor has to bridge a considerable gap to the PCB on top of the ceramic heat spreader. Moreover, the coefficients of thermal expansion (c_{TE}) of the involved materials are all different. Therefore, in cycling operation when RF is turned on and off frequently, or the RF power level is frequently changed, e. g. on a scale of seconds, the connections between the top contact of the termination resistor and the inductor experience considerable thermomechanical stress in cycling operation which is common for short semiconductor plasma processes and also during pulsing operation. These brazed or soldered joints can deteriorate rapidly and eventually break at high operating temperatures.

The connection of the flange to the cooling element experiences thermomechanical stress as the flange material, e. g. a copper molybdenum alloy which has a similar c_{TE} as the resistor material, is not matched to the c_{TE} of the cooling element which is typically made from copper or aluminum or an alloy.

CN 201 984 913 U describes a resistor assembly to fix a resistor chip by clamping. Other prior art is disclosed in documents US5592021A, US5252944A, US4259685A and JPS63266858A.

Thus, it is an objective of the present invention to provide a resistor reliably connected to a heat sink or heat spreader in a compact manner.

The problems of the prior art are solved by a resistor according to claim 1.

In a first aspect, a resistor is provided in particular for a power combiner. The resistor comprises a resistor chip. Preferably, the resistor chip comprises an area of between 50 mm² and 500 mm². Preferably, the size of the resistor chip is between 12mm x 6mm and 30mm x 14mm. Preferably, the resistor chip has a rated power of 600 W or more. Preferably, the resistor chip is built as thick film resistor, in particular based on aluminum nitride (AIN). In particular, the resistor chip has an operating temperature up to 100 °C or more. Preferably, the resistor chip has one terminal on its upper surface, and a second terminal on its lower surface. The lower surface may be fully covered with a metal layer such that the second terminal can be attached to an electrically conducting passive heat spreader that transfers the heat to the cooling element which acts as a ground connection.

According to the present invention, the resistor comprises a clamping element to clamp the resistor chip to a cooling element. Therein, a heat spreader is built to distribute the heat generated by the resistor chip and transfer it to the cooling element. Due to the clamping element, a contact between the resistor chip and the cooling element is established in order to dissipate the heat generated by the resistor chip to the cooling element. Therein, the clamping element has a clamping arm to apply a pressure to the resistor chip. Thus, by application of the pressure directly onto the resistor chip, contact between the resistor chip and the cooling element is improved. Thus, contrary to the prior art, the resistor chip itself is clamped wherein the clamping force is directly applied to the resistor chip instead of to a heat spreading element, e. g. a flange, of a resistor of the prior art as described above. Thus, the required space for fixing the resistor chip to the cooling element is reduced and consequently, the area of the resistor chip can be increased leading to an improved heat transfer away from the resistor chip. In addition, by clamping (contrary to fixing the resistor by screws as in the prior art) thermal expansion of the resistor chip is allowed, thereby reducing thermally induced stress in the resistor chip. Hence, heat dissipation from the resistor chip to the cooling element is improved and reliability as well as lifetime of the resistor is increased due to a decreased operating temperature.

Preferably, the clamping element comprises a base element connected to the clamping arm in an L-shape. Therein, in particular, the base element has a first end connected to the clamping arm and an opposite second end directly connected to or in contact with the cooling element in the mounted state. In particular, the base element and the clamping arm are one piece and integrally built. Therein, in particular, the angle between the base element and the clamping arm might be 90 ° or less. Thus, by the base element a contact point/line is created, wherein the clamping element pivots around this contact point/line in order to enable the clamp arm to apply a pressure to the resistor chip.

Preferably, the second end of the base element is inclined to allow rotation movement of the clamping element around the edge which is in a direction away from the resistor chip. Thus, the edge in a distance larger away from the resistor chip of the second end of the base element becomes the pivot point/line of the clamping element. Thereby, the pressure applied by the clamping element can be increased by up to 60 % versus the situation with a pivot line at the edge closer to the resistor chip, corresponding to a flat second end of the base element. With a flat second end of the base element, the clamping element would rotate around a pivot line on the second end of the base element which is close to the resistor chip. As an alternative to an inclined second end, the second end may comprise a protrusion providing a pivot line at a position of the second end away from the resistor chip.

Preferably, the clamping arm and the base element are made from a rigid non-magnetic material, e. g. from an aluminum alloy, brass, or an austenitic steel.

According to the invention, between the clamping arm and the resistor chip, a pressure distribution plate is arranged. By the pressure distribution plate, the pressure applied by the clamping arm is distributed over the entire area of the resistor chip. Preferably, the pressure distribution plate is a rigid element built from a metal or plastic. Preferably, the pressure distribution plate is a separate element or may be integrally built with the clamping arm. Preferably, the thickness of the pressure distribution plate is between 2 and 5 mm, wherein the area of the pressure distribution plate is preferably between 50 mm² and 400 mm².

According to the invention, the lower side of the clamping arm connected to the pressure distribution plate comprises an alignment feature and an upper surface of the pressure distribution plate comprises a corresponding alignment feature engaging the alignment feature of the clamping arm and configured to align the position of the clamping arm and the pressure distribution plate. Therein, the alignment feature may be a ball, detent, semispherical protrusion, or the like. Therein, the alignment feature of the clamping arm may be integrally built with the clamping arm or may be an additional element. Therein, a semispherical alignment feature provides a beneficial contact surface in order to evenly transfer the pressure of the clamping arm to the pressure distribution plate. Therein, the corresponding alignment feature of the pressure distribution plate has a shape corresponding to the alignment feature of the clamping arm in order to engage or receive the alignment feature of the clamping arm. Therein, the corresponding alignment feature may be built as groove, recess, dent or the like. Of course, the shapes of the alignment feature of the clamping arm and the corresponding alignment feature of the pressure distribution plate can be switched. By the alignment feature of the clamping arm and the corresponding alignment feature of the pressure distribution plate, an orientation of the pressure distribution plate is maintained.

Preferably, an insulating layer is arranged between the resistor chip and the clamping arm and preferably arranged directly between the resistor chip and the pressure distribution plate. Therein, the insulating layer may be arranged at an upper surface of the resistor chip. The insulating layer is electrically insulating. Preferably, the insulating layer is made from a high temperature elastic material like perfluoroelastomere, polyimide or polyamide. By the insulating layer, a short circuit between the in particular metallic pressure distribution plate and the resistor chip is avoided. Therein, the insulating layer may be integrally built with the pressure distribution plate, if the pressure distribution plate is built from a plastic material. Thereby, the insulating effect is inherently provided by the pressure distribution plate itself and thus, combines the element of the pressure distribution plate and the insulating layer. Alternatively, insulating layer and pressure distribution plate are separate elements. By building the insulating layer as an elastic layer, pressure distribution from the pressure distribution plate to the resistor chip is improved and slight manufacturing imperfections of the resistor chip and / or the pressure distribution plate can be compensated by the elastic insulating layer without creating a short-circuit.

Preferably, the resistor comprises pressure means connected to the clamping arm and connectable to a heat sink or heat spreader and configured to create the pressure of the clamping arm. Preferably, the pressure means are built as screw.

In particular, the pressure means extend through the clamping arm and preferably through the pressure distribution plate. Therein, in particular the through hole of the clamping arm might conform the outer diameter of the pressure means, wherein the through hole of the pressure distribution plate may be larger than the pressure means in order to allow movability of the pressure distribution plate relative to the pressure means. In addition, by the pressure means, orientation of the pressure distribution plate is maintained. In combination with the alignment feature of the clamping arm and the corresponding alignment feature of the pressure distribution plate, the position of the pressure distribution plate is determined and fixed.

Preferably, the pressure means do not extend through the resistor chip. In particular, the pressure means are distant and apart from the resistor chip. By avoiding contact between the pressure means and the resistor chip, the possibility of a short-circuit is prevented.

Preferably, at a lower surface of the resistor chip, opposite to the clamping arm, a conduction layer is arranged, wherein preferably the conduction layer is thermally conductive and / or electrically conductive. Therein, preferably the thermal conduction is larger than 200 W/m/K, more preferably larger than 300 W/m/K and most preferably larger than 400 W/m/K, thereby exceeding the heat conduction of a heat sink made for example from aluminum having a heat conduction of 240 W/m/K and / or the heat conduction of a heat spreader for example made from Al₂O₃ having a heat conduction of 30 W/m/K.

Preferably, the conduction layer is compressible. Preferably, the conduction layer has a compressibility of 10% or larger, more preferably 20% or larger. Preferably the conduction layer has a bulk modulus of less than 1000kPa, preferably 600kPa. By the compressibility of the conduction layer, small manufacturing imperfections of the resistor chip and / or the underlying surface provided by the cooling element can be compensated, thereby providing a full contact between the respective surfaces in order to enable optimum heat dissipation from the resistor chip to the cooling element.

Preferably, the conduction layer is provided by a heat transfer paste or a thermal pad or a compressible graphite thermal interface material, preferably with a compressibility of 10% or larger, more preferably of 20% or larger.

Preferably, the conduction layer provides an electrical contact between ground and the resistor chip.

Preferably, the resistor comprises a connecting element, preferably built as ribbon, connected to the resistor chip and, in particular connected at a side of the resistor chip opposite to the base element of the clamping element. Thus, in particular the connecting element is connected to a short side of the resistor chip. Therein, the connecting element may be connected to the resistor chip on a top surface thereof. Thus, by the connecting element, the resistor is electrically connected to the respective circuit. As mentioned above, the second terminal of the resistor chip may be provided by the lower surface of the resistor chip by means of a metal layer.

Preferably, the connecting element is S-shaped. By the S-shape thermal expansion can be compensated and thus cannot lead to a damage of the connecting element.

The invention is described in more detail with reference to the accompanying figures.

The figures show:
- Fig. 1: an exploded view of the resistor according to the present invention,
- Fig. 2: a side view of the resistor of Fig. 1,
- Fig. 3: a sectional view of the resistor according to Fig. 1 and
- Fig. 4: the resistor according to Fig. 1 in an assembled state of a power combiner.

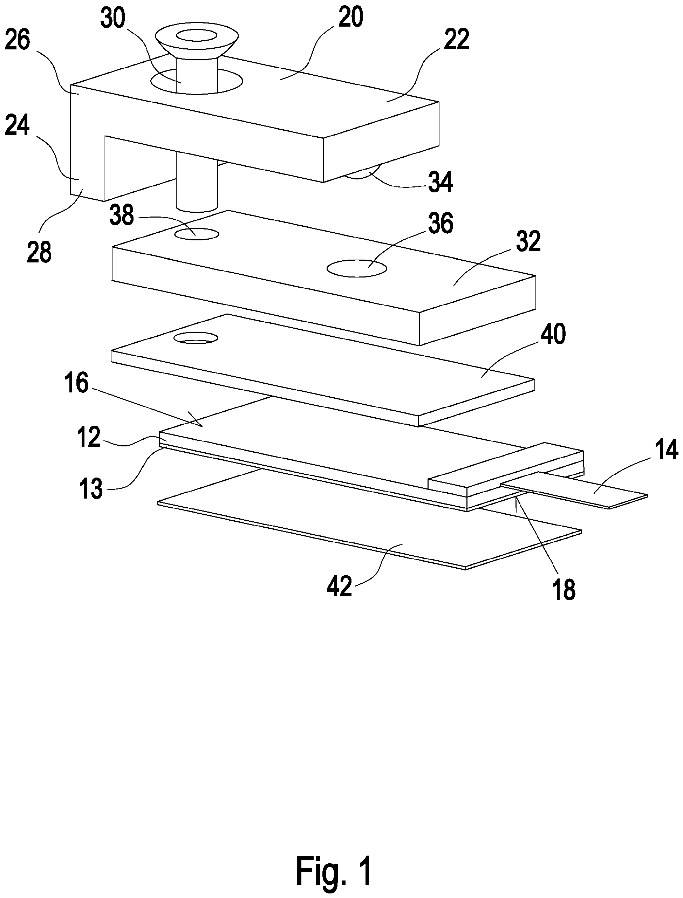

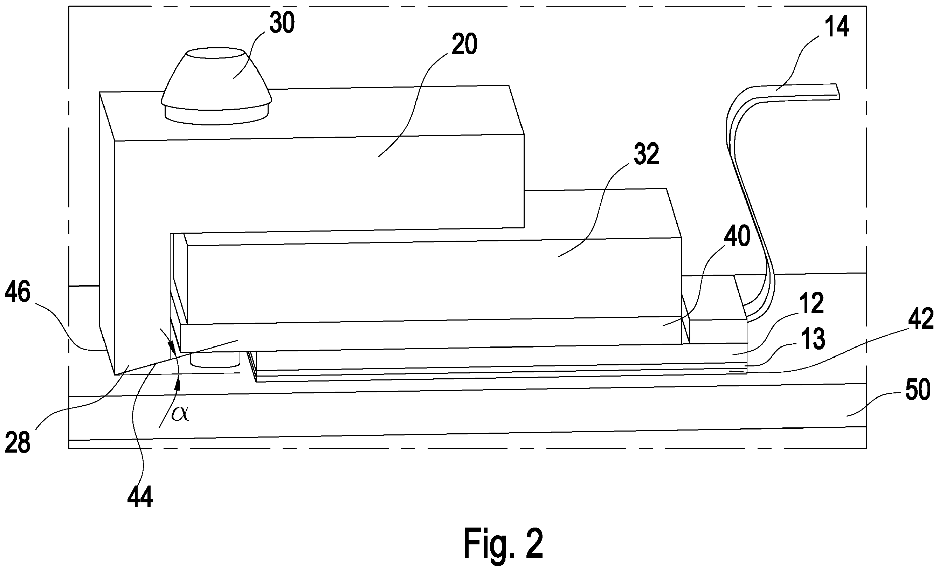

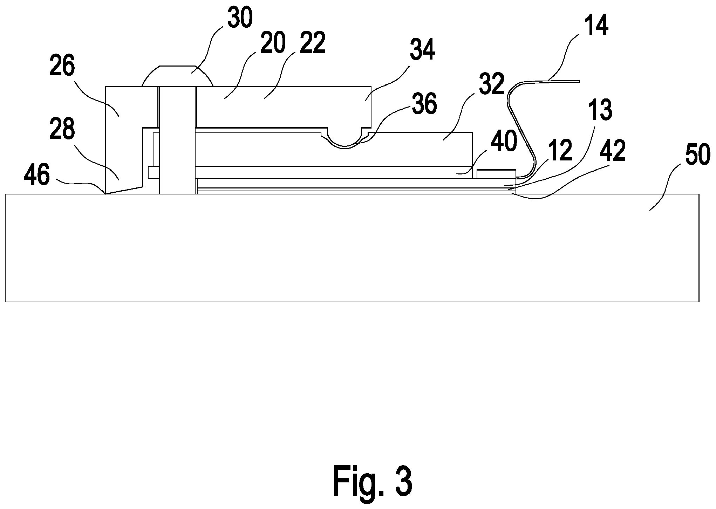

In the following it is referred to Figs. 1-3. The resistor according to the present invention comprises a resistor chip 12 having an upper surface 16 and a lower surface 18. The resistor chip 12 comprises a connecting element 14 built as ribbon. The connecting element 14 may be bent in a S-shape. The second terminal of the resistor chip 12 is provided by the lower surface 18 which is connected usually to ground. This second terminal may be a metal layer 13 which covers the lower surface 18. Further, the resistor comprises a clamping element 20 having a clamping arm 22 and a base element 24. Therein, the base element 24 comprises a first end 26 connected to the clamping arm 22 and a second end 28 which is directly connected to a cooling element 50 of a radiofrequency (RF) generator. The clamping element 20 is connected to the heat spreader 50 by a screw 30. The second end 28 of the base element 24, as shown in Fig. 2, comprises an inclined surface 44 having an angle α. By the inclined surface 44 a pivot line 46 is built at the outer edge of the base element 24, i.e. the edge farer away from the resistor chip 12. By this angle α provided by the inclined surface 44, the clamping force generated by the clamping element 20 can be increased by 60 % compared to a flat surface which would rotate around a pivot line at the edge closer to the resistor chip 12. When turning the screw 30, a pressure is applied by the clamping arm 22 to a pressure distribution plate 32. Therein, the screw 30 may extend through a through hole 38 of the pressure distribution plate 32. Further, the clamping arm 22 comprises a semispherical alignment feature 34, wherein the pressure distribution plate 32 comprises a semispherical recess 36 in order to receive the alignment feature 34 of the clamping arm 22.

Thereby, the position of the pressure distribution plate 32 is defined by the alignment feature 34 and the corresponding recess 36 together with the through hole 38 receiving the screw. The pressure distribution plate 32 distributes the pressure applied by the clamping arm 22 and is built from a rigid material such as rigid plastic or metal. Between the pressure distribution plate 32 and the upper surface 16 of the resistor chip 12 an insulating layer 40 is provided in order to electrically insulate the resistor chip 12 from the pressure distribution plate 32. Therein, the screw 30 may extend through a through hole of the insulating layer 40. The insulating layer 40 may be compressible in order to evenly distribute the pressure provided by the pressure distribution plate 32 onto the resistor chip 12 and allow thermal expansion without introducing thermal stress into the resistor chip 12. The insulating layer 40 may be made from a high temperature elastic material like perfluoroelastomere, polyimide or polyamide.

At the lower surface 18 of the resistor chip 12, between the cooling element 50 and the resistor chip 12, a conduction layer is arranged being thermally and electrically conductive. Thus, by the conduction layer contact of the lower surface 18 of the resistor chip 12 to ground is established. At the same time heat generated by the resistor chip is transferred to the cooling element 50.

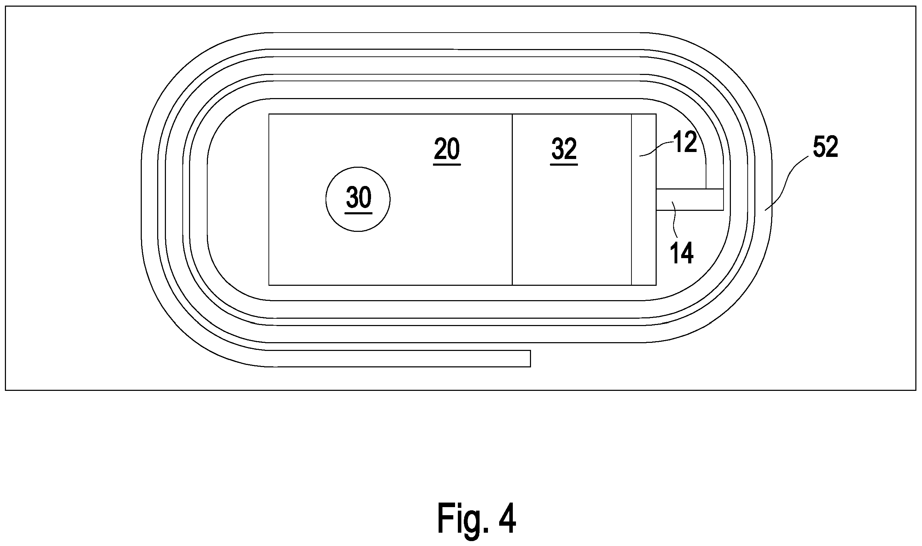

Referring to Fig. 4 showing a power not being part of the present invention which might be part of a high-power RF generator. The power combiner comprises at least one inductor 52, wherein the resistor according to the present invention is connected to the inductor 52 by its connecting element 14 as termination resistor.

Preferably, the resistor according to the present invention has an operating temperature of 80 °C or above, preferably 100 °C or above.

Wherein in the prior art, a flanged resistor connected to the cooling element by two screws allows to handle the maximum absorbed power of 400 W, the present invention increases the resistor chip area and at the same time improves thermal contact between the resistor chip and the cooling element thereby allowing up to 700 W or more of absorbed power. At the same time, the operating temperature of the resistor can be reduced by 15 °C or more.

In addition, due to a reduced operating temperature and less thermomechanical stress during power cycling, the lifetime of the soldered or brazed connection from the top contact of the resistor to the combiner PCB is increased significantly. In addition, the thermal expansion and compression of the clamped components is facilitated by means of the conductive, compressible thermal interface material which results in reduced thermomechanical stress to the resistor chip.

## Claims

1. Resistor assembly comprising
a resistor chip (12) and
a clamping element (20) to clamp the resistor chip (12) to a cooling element (50),
wherein the clamping element (20) has a clamping arm (22) to apply a pressure to the resistor chip (12),
wherein between the clamping arm (22) and the resistor chip (12) a pressure distribution plate (32) is arranged such that the pressure applied by the clamping arm (22) is distributed over the entire area of the resistor chip (12),
**characterized in that**
the lower side of the clamping arm connected to the pressure distribution plate (32) comprises an alignment feature (34), and the upper surface of the pressure distribution plate (32) comprises a corresponding alignment feature (36) engaging the alignment feature (34) of the clamping arm (22), and is configured to align the position of the clamping arm (22) and the pressure distribution plate (32).

2. Resistor assembly according to claim 1, **characterized in that** the clamping element (20) comprises a base element (24) connected to the clamping arm (22) in an L-shape, wherein preferably the base element (24) has a first end (26) connected to the clamping arm (22) and an opposite second end (28) in contact with the cooling element (50).

3. Resistor assembly according to claim 2, **characterized in that** the second end (28) of the base element (24) is inclined to allow rotational movement of the clamping element (20) around the edge which is in a direction away from the resistor chip (12).

4. Resistor assembly according to any of claims 1 to 3, **characterized by** an insulating layer (40) arranged between the resistor chip (12) and the clamping arm (22) and preferably arranged directly between the resistor chip (12) and the pressure distribution plate (32).

5. Resistor assembly according to any of claims 1 to 4, **characterized by** pressure means (30) connected to the clamping arm (22) and connectable to a heat sink or heat spreader to create the pressure of the clamping arm (22).

6. Resistor assembly according to claim 5, **characterized in that** the pressure means (30) extend through the clamping arm (22) and preferably through the pressure distribution plate (32).

7. Resistor assembly according to claim 5 or 6, **characterized in that** the pressure means (30) do not extend through the resistor chip (12) and/or the insulation film (40).

8. Resistor assembly according to any of claims 1 to 7, **characterized in that**, at a lower surface (18) of the resistor chip (12) opposite to the clamping arm (22), a conduction layer (42) is arranged, wherein preferably the conduction layer (42) is thermally conductive and/or electrically conductive.

9. Resistor assembly according to claim 8, wherein the conduction layer (42) is compressible.

10. Resistor assembly according to claim 8 or 9, wherein the conduction layer (42) is provided by a heat transfer paste or a thermal pad or a compressible graphite thermal interface material.

11. Resistor assembly according to any of claims 1 to 10, **characterized by** a connecting element (14) preferably built as ribbon, connected to the resistor chip (12) and in particular connected at a side of the resistor chip (12) opposite to the base element (24) of the clamping element (20).

## Patentansprüche

1. Widerstandsanordnung mit
einem Widerstandschip (12) und
einem Klemmelement (20) zum Klemmen des Widerstandschips (12) an ein Kühlelement (50),
wobei das Klemmelement (20) einen Klemmarm (22) zum Aufbringen eines Drucks auf den Widerstandschips (12) aufweist,
wobei zwischen dem Klemmarm (22) und dem Widerstandchip (12) eine Druckverteilungsplatte (32) derart angeordnet ist, dass der von dem Klemmarm (22) aufgebrachte Druck über die gesamte Fläche des Widerstandschips (12) verteilt wird,
**dadurch gekennzeichnet,**
**dass** die Unterseite des Klemmarms, die mit der Druckverteilungsplatte (32) verbunden ist, ein Ausrichtelement (34) aufweist, und die Oberseite der Druckverteilungsplatte (32) ein entsprechendes Ausrichtelement (36) aufweist, die mit dem Ausrichtelement (34) des Klemmarms (22) zusammengreift, und dazu ausgebildet ist, die Position des Klemmarms (22) und der und der Druckverteilungsplatte (32) auszurichten.

2. Widerstandsanordnung nach Anspruch 1, **dadurch gekennzeichnet, dass** das Klemmelement (20) ein Basiselement (24) aufweist, das mit dem Klemmarm (22) in einer L-Form verbunden ist, wobei vorzugsweise das Basiselement (24) ein mit dem Klemmarm (22) verbundenes erstes Ende (26) und ein entgegengesetztes zweites Ende (28) in Kontakt mit dem Kühlelement (50) aufweist.

3. Widerstandsanordnung nach Anspruch 2, **dadurch gekennzeichnet, dass** das zweite Ende (28) des Basiselements (24) schräg ist, um eine Drehbewegung des Klemmelements (20) um den Rand zu ermöglichen, die von dem Widerstandschip (12) weg gerichtet ist.

4. Widerstandsanordnung nach einem der Ansprüche 1 bis 3, **gekennzeichnet durch** eine Isolierschicht (40), die zwischen dem Widerstandschip (12) und dem Klemmarm (22) und vorzugsweise direkt zwischen dem Widerstandschip (12) und der Druckverteilungsplatte (32) angeordnet ist.

5. Widerstandsanordnung nach einem der Ansprüche 1 bis 4, **gekennzeichnet durch** Druckeinrichtungen (30), die mit dem Klemmarm (22) verbunden sind und mit einem Kühlkörper oder Wärmeverteiler verbindbar sind, um den Druck des Klemmarms (22) zu erzeugen.

6. Widerstandsanordnung nach Anspruch 5, **dadurch gekennzeichnet, dass** sich die Druckeinrichtung (30) durch den Klemmarm (22) und vorzugsweise durch die Druckverteilungsplatte (32) erstreckt.

7. Widerstandsanordnung nach Anspruch 5 oder 6, **dadurch gekennzeichnet, dass** sich die Druckeinrichtung (30) nicht durch den Widerstandschip (12) und/oder den Isolierfilm (40) erstreckt.

8. Widerstandsanordnung nach einem der Ansprüche 1 bis 7, **dadurch gekennzeichnet, dass** an einer Unterseite (18) des Widerstandschips (12) gegenüber dem Klemmarm (22), eine Leitschicht (42) angeordnet ist, wobei die Leitschicht (42) vorzugsweise thermisch leitfähig und/oder elektrisch leitfähig ist.

9. Widerstandsanordnung nach Anspruch 8, bei welcher die Leitschicht (42) komprimierbar ist.

10. Widerstandsanordnung nach Anspruch 8 oder 9, bei welcher die Leitschicht (42) durch eine Wärmeübertragungspaste oder ein Wärmepad oder ein komprimierbares Graphit-Wärmeleitmaterial bereitgestellt ist.

11. Widerstandsanordnung nach einem der Ansprüche 1 bis 10, **gekennzeichnet durch** ein Verbindungselement (14), das vorzugsweise als Band ausgebildet ist, mit dem Widerstandschip (12) verbunden ist und insbesondere auf einer dem Basiselement (24) des Klemmelements (20) entgegengesetzten Seite des Widerstandschips (12) verbunden ist.

## Revendications

1. Ensemble résistance comprenant
une puce de résistance (12) et
un élément de serrage (20) pour serrer la puce de résistance (12) sur un élément de refroidissement (50),
dans lequel l'élément de serrage (20) possède un bras de serrage (22) pour appliquer une pression sur la puce de résistance (12),
dans lequel entre le bras de serrage (22) et la puce de résistance (12) une plaque de répartition de pression (32) est agencée de telle sorte que la pression appliquée par le bras de serrage (22) est répartie sur toute la surface de la puce de résistance (12),
**caractérisé en ce que**
le côté inférieur du bras de serrage relié à la plaque de répartition de pression (32) comprend un élément d'alignement (34), et la surface supérieure de la plaque de répartition de pression (32) comprend un élément d'alignement correspondant (36) venant en prise avec l'élément d'alignement (34) du bras de serrage (22), et est conçu pour aligner la position du bras de serrage (22) et de la plaque de répartition de pression (32).

2. Ensemble résistance selon la revendication 1, **caractérisé en ce que** l'élément de serrage (20) comprend un élément de base (24) relié au bras de serrage (22) en forme de L, dans lequel, de préférence, l'élément de base (24) a une première extrémité (26) reliée au bras de serrage (22) et une seconde extrémité opposée (28) en contact avec l'élément de refroidissement (50).

3. Ensemble résistance selon la revendication 2, **caractérisé en ce que** la seconde extrémité (28) de l'élément de base (24) est inclinée pour permettre un mouvement de rotation de l'élément de serrage (20) autour du bord qui est dans une direction opposée à la puce de résistance (12).

4. Ensemble résistance selon l'une quelconque des revendications 1 à 3, **caractérisé par** une couche isolante (40) agencée entre la puce de résistance (12) et le bras de serrage (22) et agencée de préférence directement entre la puce de résistance (12) et la plaque de répartition de pression (32).

5. Ensemble résistance selon l'une quelconque des revendications 1 à 4, **caractérisé par** des moyens de pression (30) reliés au bras de serrage (22) et pouvant être reliés à un puits thermique ou à un dissipateur thermique pour créer la pression du bras de serrage (22).

6. Ensemble résistance selon la revendication 5, **caractérisé en ce que** le moyen de pression (30) s'étend à travers le bras de serrage (22) et de préférence à travers la plaque de répartition de pression (32).

7. Ensemble résistance selon la revendication 5 ou 6, **caractérisé en ce que** le moyen de pression (30) ne s'étend pas à travers la puce de résistance (12) et/ou le film isolant (40).

8. Ensemble résistance selon l'une quelconque des revendications 1 à 7, **caractérisé en ce que**, au niveau d'une surface inférieure (18) de la puce de résistance (12) opposée au bras de serrage (22), une couche conductrice (42) est agencée, dans lequel de préférence la couche conductrice (42) est thermiquement conductrice et/ou électriquement conductrice.

9. Ensemble résistance selon la revendication 8, dans lequel la couche conductrice (42) est compressible.

10. Ensemble résistance selon la revendication 8 ou 9, dans lequel la couche conductrice (42) est constituée d'une pâte de transfert de chaleur ou d'un tampon thermique ou d'un matériau d'interface thermique en graphite compressible.

11. Ensemble résistance selon l'une quelconque des revendications 1 à 10, **caractérisé par** un élément de liaison (14), se présentant de préférence sous la forme d'un ruban, relié à la puce de résistance (12) et en particulier relié à un côté de la puce de résistance (12) opposé à l'élément de base (24) de l'élément de serrage (20).
